Europäisches Patentamt

European Patent Office

Office européen des brevets

(19)

(11) Numéro de publication: **0 299 233 B1**

(12) **FASCICULE DE BREVET EUROPEEN**

(45) Date de publication de fascicule du brevet:
16.10.91

(51) Int. Cl.⁵: **H03K 3/57**, H03K 17/80

(21) Numéro de dépôt: **88109838.8**

(22) Date de dépôt: **21.06.88**

(54) *Générateur d'impulsions électriques de puissance avec compression temporelle et élévation de tension, notamment pour laser à décharge.*

(30) Priorité: **26.06.87 FR 8709041**

(43) Date de publication de la demande:
**18.01.89 Bulletin 89/03**

(45) Mention de la délivrance du brevet:
**16.10.91 Bulletin 91/42**

(84) Etats contractants désignés:
**AT BE CH DE ES FR GB GR IT LI LU NL SE**

(56) Documents cités:

**INSTRUMENTS AND EXPERIMENTAL TECHNI-
QUES, vol. 21, no. 5, partie 1,
septembre/octobre 1978, pages 1284-1286,
Plenum Publishing Corp.; A.V. BARMIN et al.:
"Generator of pulses for magnetron modulation in the centimeter band"**

**IEEE TRANSACTIONS ON MAGNETICS, vol.
MAG-5, no. 3, septembre 1969, pages
347-351; P.R. JOHANNESSEN: "Generation of
high-power RF pulses by means of a nonlinear magnetic coupling network"**

**IEEE TRANSACTIONS ON COMMUNICATION**

**AND ELECTRONICS, vol. 83, no. 74, septembre 1964, pages 486-494, New York, US; H.D.
CRANE et al.: "Signal switching with magnetic elements"**

(73) Titulaire: **LASERDOT
Route de Nozay
F-91460 Marcoussis(FR)**

(72) Inventeur: **Pinson Pierre
10 rue de la Fontaine Vaugrigneuse
F-91640 Briis sous Forges(FR)**

(74) Mandataire: **Weinmiller, Jürgen
Lennéstrasse 9 Postfach 24
W-8133 Feldafing(DE)**

## Description

La présente invention concerne la production d'impulsions de puissance brèves notamment dans des systèmes pouvant fonctionner à cadence élevée.

Il s'agit de fournir à une charge, qui peut par exemple être un laser, des impulsions de courant de plusieurs centaines d'ampères sous plusieurs milliers de volts pendant des durées de quelques dizaines ou centaines de nanosecondes.

L'etat de la technique est le suivant :

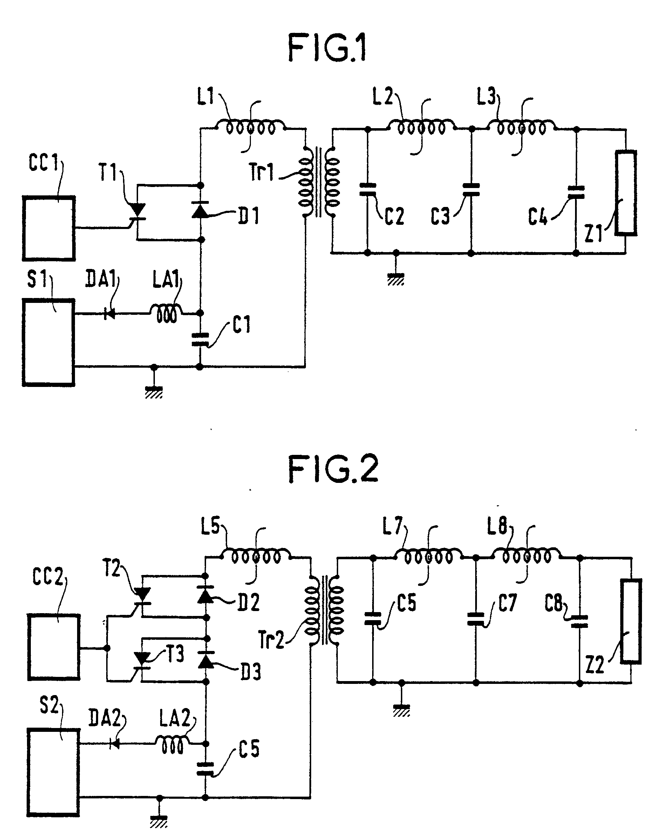

On connaît d'une part des dispositifs d'aide à la commutation utilisant des bobines à noyaux magnétiques saturables, et d'autre part des étages de compression temporelle d'impulsions qui utilisent aussi de telles bobines et qui ont d'abord été utilisés dans le domaine des radars -(voir à ce sujet le document (1) dont les références bibliographiques sont indiquées en fin de description). S'il y a besoin de travailler à forte tension (quelques Kilovolts) et en impulsions courtes (quelques dizaines ou centaines de nanosecondes) des générateurs utilisant un transformateur et des étages de compression ont étés décrits (voir à ce sujet les documents 9,10,11). En associant de tels dispositions connues un homme du métier pourrait envisager de réaliser un générateur tel que celui dont le schéma est représenté sur la figure 1.

Dans un tel générateur, une fois le régime périodique établi, un condensateur de stockage C1 est rechargé, à une cadence de fonctionnement convenable, à deux fois la valeur d'une tension continue d'alimentation à travers une diode et une bobine d'alimentation DA1 et LA1. Cette tension continue est fournie par une source S1. Lorsque la recharge du condensateur est complète, un circuit de commande CC1 fournit une impulsion de commande qui allume un thyristor de déclenchement qui constitue un interrupteur primaire T1. Le courant est au début faible car une bobine L1 à noyau magnétique saturable N1 présente une inductance initiale élevée. Au bout d'un certain temps appelé temps de saturation ou temps de blocage, ce noyau se sature et la valeur de l'inductance tombe rapidement, ce qui permet la circulation d'un courant élevé. Une telle bobine sera parfois appelée ci-après inductance saturable. Pendant le temps de blocage du courant principal par l'inductance saturable L1 le thyristor a eu le temps de devenir conducteur sur une grande partie de sa surface. Il présente donc des pertes plus faibles au moment du passage du courant principal. Une diode de récupération D1 est montée tête bêche avec le thyristor T1 pour annuler rapidement la charge négative qu'a prise le condensateur C1 après sa décharge, amorcer la recharge de ce condensateur et empêcher l'application d'une tension inverse aux bornes du thyristor. La mise en oeuvre d'un tel dispositif d'aide à la commutation permet d'utiliser des thyristors pour engendrer des impulsions plus courtes que celles qui correspondent aux spécifications habituellement indiquées par les fournisseurs de ces composants.

Les éléments S1, CC1, DA1, LA1, C1, T1 constituent ce qui sera appelé ci-après un circuit de base. Les impulsions fournies par ce circuit sont appliquées à des étages de compression à travers un transformateur Tr1 qui en élève la tension. Ces étages vont maintenant être décrits.

Une impulsion élevée en tension et fournie par l'enroulement secondaire du transformateur Tr1 est utilisée pour charger rapidement mais cependant progressivement un condensateur de stockage C2 en un temps juste inférieur au temps de saturation d'une bobine L2 à noyau magnétique saturable. Cette inductance se sature alors rapidement et la charge du condensateur C2 s'écoule dans un condensateur C3 en un temps plus court que le temps de charge de C2. Par l'intermédiaire d'une nouvelle inductance saturable L3 la charge du condensateur C3 s'écoule en un temps encore plus court dans une charge de sortie Z1 associée à un condensateur C4 en parallèle.

On a constitué ainsi un système de compression temporelle d'impulsion à deux étages successifs, à savoir un premier étage C2, L2 et un deuxième C3, L3. Ceci permet de reporter la fonction de commutateur initial sur un composant capable de commuter toute l'énergie nécessaire mais en un temps beaucoup plus long que la durée de décharge finale exigée par l'application envisagée -voir le document (2)-.

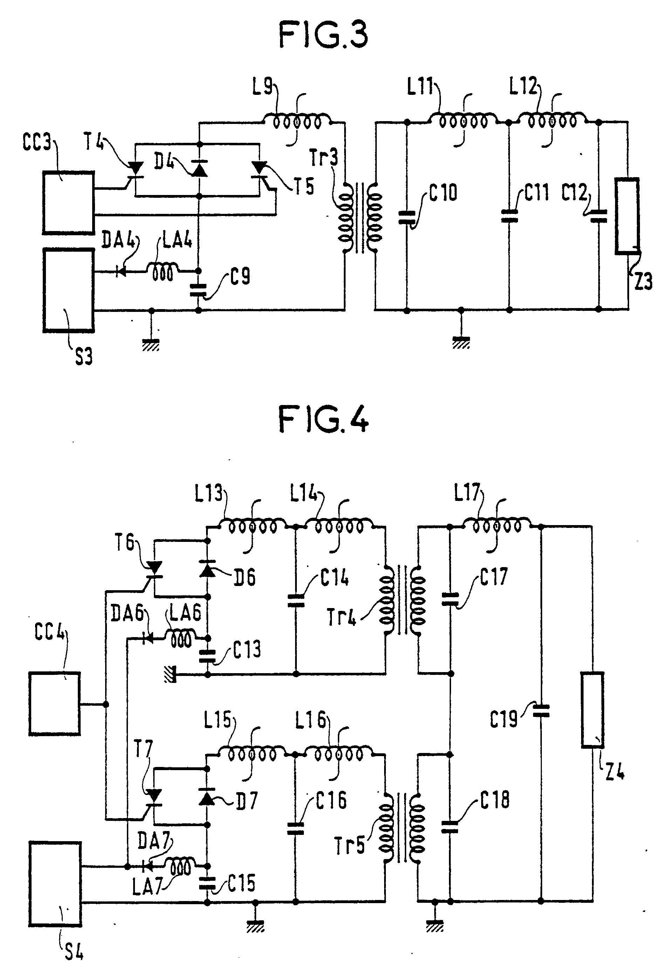

Un tel générateur serait limité en puissance moyenne par le courant et la tension que peuvent supporter les interrupteurs primaires les plus convenables connus qui sont des thyristors à semiconducteurs. Pour augmenter cette puissance on a la possibilité de mettre plusieurs thyristors en série (figure 2) ou en parallèle (figure 3) pour travailler à plus forte tension ou à plus fort courant, respectivement.

Sur ces deux figures de même que sur les figures suivantes sont représentés des circuits de base, des transformateurs élévateurs de tension et des étages de compression qui fonctionnent selon les principes précédemment décrits pour appliquer une impulsion de sortie de générateur à une charge finale. Pour éviter de répéter la description de ces éléments et de leurs fonctions les éléments qui se correspondent sur les figures 1, 2 et 3 sont indiqués sur une même ligne horizontale dans le tableau ci-après.

| FIGURE 1 | FIGURE 2 | FIGURE 3 |
|----------|----------|----------|
| S1 | S2 | S3 |
| DA1 | DA2 | DA4 |
| LA1 | LA2 | LA4 |
| C1 | C5 | C9 |
| T1 | T2 et T3 | T4 et T5 |
| CC1 | CC2 | CC3 |
| D1 | D2 et D3 | D4 |
| L1 | L5 | L9 |
| Tr1 | Tr2 | Tr3 |
| C2 | C6 | C10 |
| L2 | L7 | L11 |
| C3 | C7 | C11 |
| L3 | L8 | L12 |
| C4 | C8 | C12 |
| Z1 | Z2 | Z3 |

La mise en série des thyristors conformément à la fig.2 est possible mais elle est délicate car les thyristors doivent être parfaitement synchronisés lors de la commutation.

La mise en parallèle fonctionne correctement (voir figure 3). Mais si l'on voulait augmenter ainsi la puissance moyenne il faudrait choisir une valeur augmentée pour le condensateur C9 ce qui augmenterait le temps de transfert de l'énergie de C9 vers C10. De plus si l'on veut une tension de sortie élevée en sortie du générateur, il faudrait choisir un transformateur élévateur de tension Tr3 présentant un rapport de transformation élevé. Or on sait que le rendement d'un tel transformateur travaillant en impulsions est mauvais. Il en résulterait des pertes gênantes d'énergie.

La présente invention a notamment pour but de permettre d'engendrer des impulsions de sortie brèves présentant une tension et une énergie accrues.

Elle a en même temps pour but de permettre d'engendrer de telles impulsions avec de faibles pertes d'énergie et en utilisant pour cela un volume modéré de matériau ferromagnétique comme noyaux magnétique de transformateurs ou d'inductances saturables.

De manière générale, son objet est un générateur d'impulsions électriques de puissance avec compression temporelle et élévation de tension. Ce générateur est prévu pour appliquer à une charge une impulsion électrique de sortie énergétique et brève à tension élevée, et il comporte pour cela :
- un circuit de base pour engendrer une impulsion électrique de base présentant une durée plus grande et une tension plus basse que ladite impulsion de sortie,
- un transformateur élévateur de tension présentant un enroulement primaire recevant une impulsion provenant de ladite impulsion de base, et un enroulement secondaire fournissant une impulsion élevée en tension,
- et un étage de compression comportant un condensateur de stockage chargé progressivement par une impulsion provenant de ladite impulsion de base,
- cet étage comportant encore une bobine de compression temporelle connectée en série avec ce condensateur de stockage pour permettre de fournir une impulsion comprimée par décharge de ce condensateur à travers cette bobine, cette bobine comportant pour cela un noyau en matériau ferromagnétique saturable qui lui confère une inductance initiale importante qui s'oppose à une croissance rapide du courant de la décharge de ce condensateur de stockage tant que l'intensité de ce courant reste inférieure à un seuil de saturation, ceci ayant lieu au début de cette décharge avant la charge complète de ce condensateur, cette inductance prenant ensuite une valeur de saturation minime que résulte de la saturation dudit matériau ferromagnétique et qui permet à ce courant de décharge de croître rapidement pour constituer ladite impulsion comprimée, ladite impulsion de base transitant successivement par ledit transformateur élévateur et par ledit étage de compression pour former une impulsion de sortie à la fois élevée en tension et comprimée en temps.

Ce générateur est caractérisé par le fait qu'il comporte au moins un premier et un second dits circuits de base pour fournir en même temps une première et une seconde dites impulsions de base,

-   ledit étage de compression comportant au moins un premier et un second dits condensateurs de stockage chargés indépendamment l'un de l'autre par cette première et cette deuxième impulsions de base, respectivement, ces deux condensateurs de stockage étant connectés en série au sein de cet étage de compression de manière à réaliser une addition des tensions que ces deux impulsions de base font apparaître à leurs bornes, et à augmenter ainsi la tension de ladite impulsion de sortie tout en découplant ces deux circuits de base pour éviter que des décalages temporels éventuels entre les fonctionnements de ces deux circuits ne perturbent ces fonctionnements.

A l'aide des figures schématiques 4, 6 et 7 ci-jointes on va décrire plus particulièrement ci-après trois générateurs selon trois modes de mise en oeuvre de l'invention. On rappelle que les figures 1, 2 et 3 précédemment décrites représentent les schémas d'un premier, d'un deuxième et d'un troisième générateurs qu'un homme du métier pourrait envisager de réaliser pour augmenter la tension et l'énergie des impulsions de sortie.

La figure 4 représente le schéma d'un premier générateur selon l'invention.

La figure 5 représente le schéma d'un générateur qui pourrait être envisagé pour réaliser une addition de tensions par mise en série des enroulements secondaires de deux transformateurs.

La figure 6 représente le schéma d'un deuxième générateur selon l'invention.

La figure 7 représente le schéma d'un troisième générateur selon l'invention.

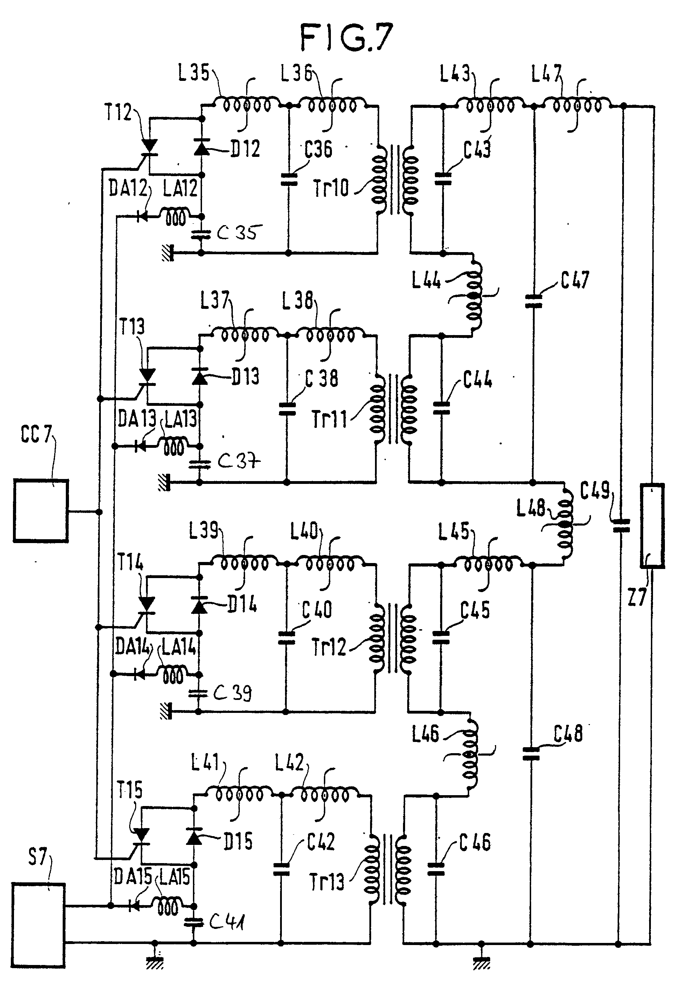

Les générateurs des figures 4 à 6 comportent chacun deux circuits de base fonctionnant sur le principe décrit à l'aide de la figure 1. Le générateur de la figure 7 en comporte quatre. A la sortie de chacun de ces circuits est connecté un transformateur élévateur de tension qui, sur ces figures 4 à 7 est précédé d'un circuit de compression temporelle comportant un condensateur de stockage tel que C14 et une bobine de compression à noyau saturable telle que L14. La charge de sortie telle que Z4 du générateur (un laser à décharge) est toujours associée à un condensateur en parallèle tel que C4. Pour éviter des répétitions, et comme à propos des figures 1, 2 et 3, certains éléments qui se correspondant dans ces divers générateurs sont indiqués dans le tableau ci-dessous.

| Figure 1 S1 | Figure 4 S4 | | Figure 5 S5 | | Figure 6 S6 | | Figure 7 S7 | | | |
|---|---|---|---|---|---|---|---|---|---|---|
| DA1 | DA6 | DA7 | DA8 | DA9 | DA10 | DA11 | DA12 | DA13 | DA14 | DA15 |
| LA1 | LA6 | LA7 | LA8 | LA9 | LA10 | LA11 | LA12 | LA13 | LA14 | LA15 |
| C1 | C13 | C15 | C20 | C22 | C27 | C29 | C36 | C38 | C40 | C42 |
| T1 | T6 | T7 | T8 | T9 | T10 | T11 | T12 | T13 | T14 | T15 |
| CC1 | CC4 | | CC5 | | CC6 | | CC7 | | | |
| D1 | D6 | D7 | D8 | D9 | D10 | D11 | D12 | D13 | D14 | D15 |
| L1 | L13 | L15 | L20 | L22 | L27 | L29 | L36 | L38 | L40 | L42 |
| Tr1 | Tr4 | Tr5 | Tr6 | Tr7 | Tr8 | Tr9 | Tr10 | Tr11 | Tr12 | Tr13 |
| | C14 | C16 | C21 | C23 | C28 | C30 | C36 | C38 | C40 | C42 |
| | L14 | L16 | L21 | L23 | L28 | L30 | L36 | L38 | L40 | L42 |
| Z1 C4 | Z4 C19 | | Z5 C25 | | Z6 C33 | | Z7 C49 | | | |

Ces figures font apparaître une symétrie constructive des générateurs qui est non seulement apparente mais auusi réelle en ce sens que les éléments qui se correspondent dans deux circuits de base ou deux étages de compression d'un même générateur sont identiques de même que les transformateurs et condensateurs de stockage associés à deux tels circuits correspondants.

Lors de la formation d'une impulsion dans le premier générateur selon l'invention (fig.4), le condensateur C17 a été chargé à plus forte tension et plus rapidement que C13 ne s'est déchargé. Il en est de même pour C18 par rapport à C15.

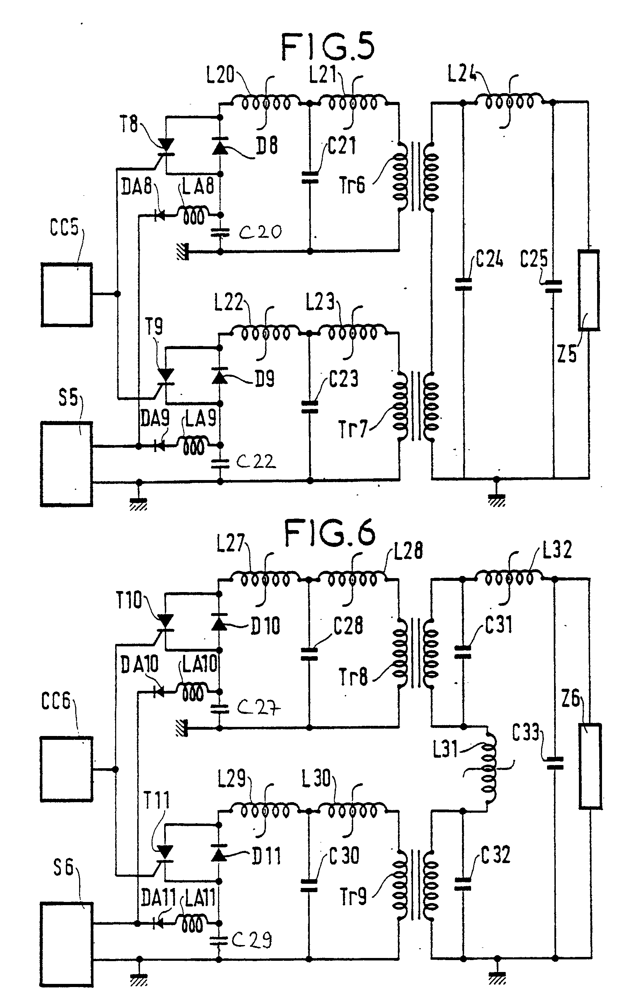

La somme des énergies stockées transitoirement dans C17 et C18 est transférée dans C19 et la charge Z4 par l'intermédiaire de l'inductance saturable L17. Ce type de mise en série est différent d'une simple mise en série qui pourrait être faite selon le schéma de la figure 5. Ce dernier type de mise en série présenterait l'inconvénient que ce serait le même courant qui circulerait dans les secondaires des deux transformateurs Tr6 et Tr7 dont les fonctionnements serait ainsi complètement liés et par conséquent, le plus souvent perturbés en raison des petites différences inévitables qui existent entre les composants disponibles dans le commerce.

Au contraire, dans le générateur de la figure 4, les fonctionnements des transformateurs Tr4 et Tr5 sont découplés en raison des constantes de temps de fonctionnement différentes des circuits d'une part Tr4, C17 et Tr5, C18 (plus lents) et d'autre part C17, C18, L17, C19 (plus rapides).

Un meilleur découplage en particulier vis-à-vis des capacités parasites des transformateurs Tr4 et Tr5 peut être obtenu en utilisant un générateur tel que celui de la figure 6 dans lequel deux bobines L31 et L32 ont une inductance moitié de celle de la bobine L17 de la figure 4, toutes choses étant égales par ailleurs. Plus généralement, dans un générateur selon l'invention analogue au deuxième générateur représenté sur la figure 6, ledit étage de compression C31, C32, L31, L32 comporte au moins deux dites bobines de compression L31, L32 à noyaux en matériau ferromagnétique saturable. Une telle bobine L32 au moins est une bobine extérieure connectée en série entre l'ensemble desdits condensateurs de stockage C31, C32 de cet étage et ladite charge C33, Z6. Une autre telle bobine L31 au moins est une bobine intermédiaire connectée en série entre deux dits condensateurs de stockage. L'interposition d'une telle bobine intermédiaire permet de découpler davantage les deux circuits de base C27, T10, L27, et C29, T11, L29.

L'extrapolation à un plus grand nombre de circuits mis en série de la sorte est possible. On préfèrera généralement une association deux par deux en plusieurs étages pour minimiser la section de matériau magnétique nécessaire, ce qui est souhaitable pour minimiser les pertes d'énergie. Une telle association est réalisée dans le troisième générateur selon l'invention qui est représenté sur la figure 7. Plus précisément ce générateur comporte deux groupes de deux dits circuits de base pour fournir en même temps quatre dites impulsions de base. Les deux circuits de base d'un même groupe T12, C35, L35, et T13, C37, L37 fournissent deux impulsions à deux dits condensateurs de stockage C43, C44 connectés en série au sein d'un dit étage de compression C43, C44, L43, L44 associé à ce groupe. Cet étage fournit une impulsion de sortie de ce groupe à une charge de ce groupe. Cette charge est constituée par un condensateur de stockage C47 associé à ce groupe et connecté aux bornes de cet étage. Les deux condensateurs de stockage C47, C48 associés à ces deux groupes sont connectés en série au sein d'un étage de compression qui est commun à ces deux groupes et qui comporte en outre au moins une dite bobine de compression L47, L48 en série avec ces deux condensateurs. Ceci permet de fournir, à une charge de sortie C49, Z7 du générateur, une impulsion de sortie du générateur dont la tension est augmentée par l'addition des tensions des impulsions de sortie des deux groupes. Ceci permet en même temps de découpler les deux groupes pour éviter de perturber leurs fonctionnements comme précédemment expliqué.

Plus particulièrement, dans ce générateur, un premier groupe est constitué par les circuits de base comportant les thyristors T12 et T13 et un second par ceux comportant les thyristors T14 et T15. Aux deux circuits du premier groupe sont associés deux condensateurs de stockage C43 et C44, respectivement qui font partie d'un étage de compression associé à ce groupe. Cet étage comporte en outre deux inductances saturables, l'une extérieure L43 et l'autre intermédiaire L44. Les références des éléments correspondants associés au second groupe sont C45, C46, L45, L46, respectivement. A ces deux groupes sont associés les condensateurs de stockage C47 et C48, respectivement, ceci au sein dudit étage de compression commun qui comporte en outre deux inductances saturables l'une extérieure L47 l'autre intermédiaire L48.

Les transformateurs Tr10, Tr11, Tr12, Tr13 ayant un même rapport de transformation n les condensateurs C43 à C46 sont chargés transitoirement de façon simultanée à une tension approchant n fois la tension V fournie par la source S7.

Les inductances saturables identiques L43 à L46 permettent de transférer plus rapidement l'énergie respectivement de C43, C44 vers C47 et de C45, C46 vers C48 à une tension voisine de 2n fois V.

A leur tour les inductances saturables identiques L47 et L48 permettent de transférer l'énergie plus rapidement des condensateurs C47, C48 vers le condensateur C49 à une tension voisine de 4n fois V.

On peut consulter les documents suivants :

(1) S.W. MELEVILLE "The use of saturable reactors as discharge devices for pulse generators" Proc.Institution of Electrical Engineers (IEE, London, England, 1951) Vol (3), p 185-207.

(2) D.L. BIRX, E,J. LAUR, L.L. REGINATO, J. SCHMIDT, M. SMITH Basic principles governing the design of magnetic switches LLNL UCID18831 nov 1980.

(3) W.C. NUNNALLY Magnetic switches and circuits LANL LA 8862-MS sept 81.

(4) W.C. NUNNALLY Stripline magnetic modulators for lasers and accelerators 3° IEEE Int. Pulsed Power Conf. 1981.

(5) D.L. BIRX, E.J. LAUER, L.L. REGINATO, D. ROGERS, M.W. SMITH, T. ZIMMERMAN 3° IEEE Int. Pulsed Power Conf. 1981.

(6) J.P. VANDEVENDER, R.A. REBER High voltage magnetically switched pulsed power systems 3° IEEE Int. Pulsed Power Conf. 1981.

(7) S.E. BALL, T.R. BURKES Saturable inductors as high power switches 3° IEEE Int. Pulsed Power Conf. 1981.

(8) C.H. SMITH, M. ROSEN Amorphous metal reactor cores for switching applications PCI'81 Proceedings.

(9) I. SMILANSKI, S.R. BYRON, T.R. BURDES Electrical excitation of an XeCl laser using magnetic pulse compression Appl. Phys. Lett. 40(7) 1981.

(10) T. SHIMADA, M. OBARA, A. NOGUCHI An all solid state magnetic switching exciter for pumping excimer lasers Rev.Sci Instrum. 56(11) 1985.

(11) H.J. BAKER, P.A. ELLSMORE, E.C. SILLE Efficient solid state magnetic pulser for gas laser excitation using ferrite materials WK27 CLEO'86 June 1986.

## Revendications

1. Générateur d'impulsions électriques de puissance avec compression temporelle et élévation de tension, pour appliquer à une charge une impulsion électrique de sortie énergétique et brève à tension élevée, ce générateur comportant pour cela,
   - un circuit de base pour engendrer une impulsion électrique de base présentant une durée plus grande et une tension plus basse que ladite impulsion de sortie,

- un transformateur élévateur de tension (Tr4) présentant un enroulement primaire recevant une impulsion provenant de ladite impulsion de base, et un enroulement secondaire fournissant une impulsion élevée en tension,
- et un étage de compression comportant un condensateur de stockage (C17) chargé progressivement par une impulsion provenant de ladite impulsion de base,
- cet étage comportant encore une bobine de compression temporelle (L17) connectée en série avec ce condensateur de stockage pour permettre de fournir une impulsion comprimée par décharge de ce condensateur à travers cette bobine, cette bobine comportant pour cela un noyau en matériau ferromagnétique saturable qui lui confère une inductance initiale importante qui s'oppose à une croissance rapide du courant de la décharge de ce condensateur de stockage tant que l'intensité de ce courant reste inférieure à un seuil de saturation, ceci au début de cette décharge avant la charge complète de ce condensateur, cette inductance prenant ensuite une valeur de saturation minime qui résulte de la saturation dudit matériau ferromagnétique et qui permet à ce courant de décharge de croître rapidement pour constituer ladite impulsion comprimée, ladite impulsion de base transitant successivement par ledit transformateur élévateur et par ledit étage de compression pour former une impulsion de sortie à la fois élevée en tension et comprimée en temps,
- ce générateur étant caractérisé par le fait qu'il comporte au moins un premier (C13, T6, L13) et un second (C15, T7, L15) dits circuits de base pour fournir en même temps une première et une seconde dites impulsions de base,
- ledit étage de compression comportant au moins un premier (C17) et un second (C18) dits condensateurs de stockage chargés indépendamment l'un de l'autre par cette première et cette deuxième impulsions de base, respectivement, ces deux condensateurs de stockage étant connectés en série au sein de cet étage de compression de manière à réaliser une addition des tensions que ces deux impulsions de base font apparaître à leurs bornes, et à augmenter ainsi la tension de ladite impulsion de sortie tout en découplant ces deux circuits de base pour éviter que des décalages temporels éventuels entre les fonctionnements de ces deux circuits ne perturbent ces fonctionnements.

2. Générateur selon la revendication 1, caractérisé par le fait que ledit étage de compression (C31, C32, L31, L32) comporte au moins deux dites bobines de compression (L31, L32) à noyaux en matériau ferromagnétique saturable, une telle bobine (L32) au moins étant une bobine extérieure connectée en série entre l'ensemble desdits condensateurs de stockage (C31, C32) de cet étage et ladite charge (C33, Z6), une autre telle bobine (L31) au moins étant une bobine intermédiaire connectée en série entre deux dits condensateurs de stockage de manière à découpler davantage les deux dits circuits (C27, T10, L27, C29, T11, L29).

3. Générateur selon la revendication 1 dans lequel lesdits circuits de base (S4, C13, T6, L13, C14, L14, S4, C15, T7, L15, C16, L16) et lesdits condensateurs de stockage (C17, C18) sont aux nombres de deux et sensiblement identiques, au moins fonctionnellement.

4. Générateur selon l'ensemble des revendications 2 et 3, caractérisé par le fait que lesdites bobines de compression temporelle (L31, L32) sont au nombre de deux et sensiblement identiques du moins quant à leurs inductances initiales et à leurs seuils de saturation.

5. Générateur selon la revendication 1, caractérisé par le fait que deux dits transformateurs élévateurs de tension (Tr4, Tr5) sont interposés entre les deux dits circuits de base (C13, T6, L13, C15, T7, L15) et les deux dits condensateurs de stockage (C17, C18) respectivement.

6. Générateur selon la revendication 1, caractérisé par le fait qu'il comporte deux groupes de deux dits circuits de base pour fournir en même temps quatre dites impulsions de base, les deux circuits de base d'un même groupe (T12, C35, L35, T13, C37, L37) fournissant deux impulsions à deux dits condensateurs de stockage (C43, C44) connectés en série au sein d'un dit étage de compression (C43, C44, L43, L44) associé à ce groupe pour fournir une impulsion de sortie de ce groupe à une charge de ce groupe,

- cette charge de ce groupe étant constituée par un condensateur de stockage (C47) associé à ce groupe, et connecté aux bornes de cet étage,.

- les deux condensateurs de stockage (C47, C48) associés à ces deux groupes étant connectés en série au sein d'un étage de compression qui est commun à ces deux groupes et qui comporte en outre au moins une dite bobine de compression (L47, L48) en série avec ces deux condensateurs, de manière à fournir, à une charge de sortie (C49, Z7) du générateur, une impulsion de sortie du générateur dont la tension est augmentée par addition des tensions des impulsions de sortie des deux groupes, tout en découplant les deux groupes.

7. Générateur selon la revendication 5, dans lequel chaque dit circuit de base (C13, T6, L13, C14, L14) comporte en sortie un étage de compression temporelle (C14, L14) alimentant l'enroulement primaire dudit transformateur élévateur de tension (Tr4).

8. Générateur selon la revendication 1, dans lequel chaque dit circuit de base comporte
   - un condensateur de stockage (C13),
   - des moyens (S4, DA6, LA6) pour charger ce condensateur,
   - un thyristor de déclenchement (T6),
   - une diode de récupération (D6) montée tête-bêche avec ce thyristor,
   - des moyens de déclenchement (CC4) communs aux divers circuits de base pour allumer ce thyristor,
   - et une bobine de compression temporelle (L13) à noyau en matériau magnétique saturable, cette bobine étant connectée en série avec ce condensateur et ce thyristor.

**Claims**

1. An electric power pulse generator providing time compression and voltage elevation, for applying an electric high power output pulse having a short duration and an elevated voltage to a load, said generator comprising:
   - a base circuit for generating an electric base pulse having a duration which is longer and a voltage which is lower than that of the output pulse,
   - a voltage elevating transformer (Tr4) having a primary winding, which is adapted to receive a pulse constituted by said base pulse, and having a secondary winding adapted to deliver a pulse elevated in voltage,
   - and a compression stage comprising a storage capacitor (C17) which is charged progressively by a pulse provided by said base pulse,
   - said stage further comprising a time compression coil (L17) connected in series to the storage capacitor in order to deliver a compressed pulse by means of discharging said capacitor via said coil, said coil comprising therefore a core made of saturable ferromagnetic material adapted to confer to it an important initial inductance, which opposes to a rapid increase of the discharge current of said storage capacitor as long as the intensity of the current remains below a saturation threshold, with this behaviour taking place at the beginning of the discharge prior to the complete charging of said capacitor, said inductance assuming thereupon a very small saturation value due to the saturation of said ferromagnetic material and which allows the discharge current to increase rapidly in order to constitute said compressed pulse, said base pulse passing successively said voltage elevating transformer and said compression stage in order to form an output pulse which is at the same time elevated in voltage and compressed in time, characterized in that it comprises at least a first (C13, T6, L13) and a second base circuit (C15, T7, L15) for delivering at the same time a first and a second base pulse,
   - said compression stage comprising at least a first (C17) and a second storage capacitor (C18) which are charged independently from each other by said first and said second base pulse, respectively, these two storage capacitors being connected in series in said compression stage such as to perform an addition of the voltages, which the two base pulses cause to appear at their terminals, and as to increase thereby the voltage of said output pulse while discoupling said two base circuits, so that possible time offsets between the operation of the two circuits do not disturb said operation.

2. A generator according to claim 1, characterized in that said compression stage (C31, C32, L31, L32) includes at least two compression coils (L31, L32) having cores of saturable ferromagnetic material, one such coil (L32) at least being an external coil connected in series between the unit of said storage capacitors (C31, C32) of said stage and said load (C33, Z6), and another such coil (L31) at least being an intermediate coil connected in series between two storage capacitors in such a way as to improve discoupling of the two base circuits (C27, T10, L27, C29, T11, L29).

3. A generator according to claim 1, in which said base circuits (S4, C13, T6, L13, C14, L14, S4, C15, T7, L15, C16, L16) and said storage capacitors (C17, C18) are two in number and are substantially identical, at least in operation.

4. A generator according to claims 2 and 3, characterized in that said time compression coils (L31, L32) are two in number and substantially identical at least with regard to their initial inductances and to their saturation thresholds.

5. A generator according to claim 1, characterized in that said two voltage elevating transformers (Tr4, Tr5) are interposed between the two base circuits (C13, T6, L13, C15, T7, L15) and the two storage capacitors (C17, C18), respectively.

6. A generator according to claim 1, characterized in that it includes two groups of two base circuits for providing four base pulses at the same time, the two base circuits of a same group (T12, C35, L35, T13, C37, L37) delivering two pulses to two so-called storage capacitors (C43, C44), which are connected in series within a compression stage (C43, C44, L43, L44), which is associated with this group for delivering an output pulse of this group to a load of said group,
   - this load of this group being constituted by a storage capacitor (C47) associated with this group and connected to the terminals of this stage, and
   - the two storage capacitors (C47, C48) associated with said two groups being connected in series within a compression stage, which is common to said two groups and which includes in addition at least one compression coil (L47, L48) connected in series with these two capacitors, in such a way as to deliver an output pulse of the generator to an output load (C49, Z7) of the generator, the voltage of said pulse being increased by addition of the voltages of the output pulses of the two groups while discoupling the two groups.

7. A generator according to claim 5, in which each base circuit (C13, T6, L13, C14, L14) includes a time compression stage (C14, L14) connected to the output and feeding the primary winding of said voltage elevating transformer (Tr4).

8. A generator according to claim 1, in which each base circuit comprises:
   - a storage capacitor (C13),
   - means (S4, DA6, LA6) for charging said capacitor,
   - a switching thyristor (T6),
   - a regeneration diode (D6) mounted inversely with said thyristor,
   - firing means (CC4) common to the different base circuits for firing said thyristor,
   - and a time compression coil (L13) having a core of saturable magnetic material, said coil being connected in series with this capacitor and this thyristor.

**Patentansprüche**

1. Elektrischer Leistungsimpulsgenerator mit Zeitkompression und Spannungserhöhung zum Anlegen eines elektrischen Ausgangsleistungsimpulses kurzer Dauer und hoher Spannung an eine Last, wobei der Generator zu diesem Zweck folgende Komponenten aufweist:
   - eine Basisschaltung zur Erzeugung eines elektrischen Basisimpulses, der eine größere Dauer und eine niedrigere Spannung besitzt als der Ausgangsimpuls,
   - einen Spannungserhöhungstransformator (Tr4) mit einer Primärwicklung, die einen vom Basisimpuls kommenden Impuls empfängt, und mit einer Sekundärwicklung, die einen Impuls erhöhter Spannung liefert,
   - und eine Kompressionsstufe mit einem Speicherkondensator (C17), der durch einen vom Basisimpuls kommenden Impuls zunehmend aufgeladen wird,
   - wobei diese Stufe weiter eine Zeitkompressionsspule (L17) aufweist, die mit diesem Speicherkondensator in Reihe geschaltet ist, um die Lieferung eines komprimierten Impulses durch Entladen dieses Kondensators über diese Spule zu ermöglichen, wobei die Spule zu diesem Zweck einen Kern aus ferromagnetischem, sättigbarem Material aufweist, der ihr eine beträchtliche Anfangsinduktanz verleiht, welche sich einem raschen Ansteigen des Entladungsstroms dieses Speicherkondensators solange widersetzt, wie die Stärke des Stroms unterhalb einer Sättigungsschwelle bleibt, nämlich am Anfang der Entladung vor der vollständigen Ladung des Kondensators, worauf die Induktanz einen minimalen Sättigungswert annimmt, der sich aus der Sättigung des ferromagnetischen Materials ergibt und der es dem Entladestrom ermöglicht, zum Aufbau des komprimierten Impulses rasch anzusteigen, und wobei der Basisimpuls nacheinander den Spannungserhöhungstransformator und die Kompressionsstufe durchläuft, um einen Ausgangsimpuls zu bilden, der zugleich eine hohe Spannung besitzt und zeitlich komprimiert ist,

- wobei der Generator dadurch gekennzeichnet ist, daß er mindestens eine erste (C13, T6, L13) und eine zweite Bassischaltung (C15, T7, L15) aufweist, die zugleich eine ersten und einen zweiten Basisimpuls liefern,
- wobei die Kompressionstufe mindestens einen ersten (C17) und einen zweiten Speicherkondensator (C18) aufweist, welche jeweils unabhängig voneinander durch den ersten bzw. durch den zweiten Basisimpuls aufgeladen werden, wobei die beiden Speicherkondensatoren innerhalb der Kompressionsstufe in Reihe geschaltet sind, derart, daß sie eine Addition der Spannungen bewirken, welche die beiden Basisimpulse an den Klemmen der Stufe in Erscheinung treten lassen, und daß sie auf diese Weise die Spannung der Ausgangsimpulse bei gleichzeitiger Entkopplung der beiden Basisschaltungen erhöhen, um zu verhindern, daß die möglicherweise auftretenden Zeitverschiebungen zwischen den Betriebsabläufen der beiden Schaltungen die genannten Funktionen stören.

2. Generator nach Anspruch 1, dadurch gekennzeichnet, daß die Kompressionsstufe (C31, C32, L31, L32) mindestens zwei Kompressionsspulen (L31, L32) mit Kernen aus ferromagnetischem, sättigbarem Material aufweist, wobei mindestens eine solche Spule (L32) eine äußere Spule ist, die mit der Gesamtheit der Speicherkondensatoren (C31, C32) der Stufe und der Last (C33, Z6) in Reihe geschaltet ist, während mindestens eine weitere solche Spule (L31) eine Zwischenspule ist, die zwischen den Speicherkondensatoren in Reihe geschaltet ist, derart, daß die beiden Basisschaltungen (C27, T10, L27, C29, T11, L29) besser entkoppelt werden.

3. Generator nach Anspruch 1, bei welchem die Basisschaltungen (S4, C13, T6, L13, C14, L14, S4, C15, T7, L15, C16, L16) und die Speicherkondensatoren (C17, C18) zweimal vorhanden und im wesentlichen identisch sind, zumindest betriebsmäßig.

4. Generator gemäß den Ansprüchen 2 und 3, dadurch gekennzeichnet, daß die Zeitkompressionsspulen (L31, L32) zweimal vorhanden und im wesentlichen identisch sind, zumindest was ihre Anfangsinduktanzen und ihre Sättigungsschwellen anbetrifft.

5. Generator nach Anspruch 1, dadurch gekennzeichnet, daß die beiden Spannungserhöhungstranformatoren (Tr4, Tr5) jeweils zwischen zwei Basisschaltungen (C13, T6, L13, C15, T7, L15) und die beiden Speicherkondensatoren (C17, C18) geschaltet sind.

6. Generator nach Anspruch 1, dadurch gekennzeichnet, daß er zwei Gruppen zu je zwei Basisschaltungen für die gleichzeitige Lieferung von vier Basisimpulsen aufweist, wobei die beiden Basisschaltungen einer Gruppe (T12, C35, L35, T13, C37, L37) zwei Impulse an zwei Speicherkondensatoren (C43, C44) liefern, die in einer der Kompressionsstufen (C43, C44, L43, L44) in Reihe geschaltet sind, welche mit dieser Gruppe zur Lieferung eines Ausgangsimpulses dieser Gruppe an eine Last der Gruppe verbunden ist,

- wobei die Last der Gruppe aus einem Speicherkondensator (C47) besteht, der der Gruppe zugeordnet und an die Klemmen der Stufe angeschlosseen ist, und
- wobei zwei mit den beiden Gruppen verbundene Speicherkondensatoren (C47, C48) in einer Kompressionsstufe in Reihe geschaltet sind, die den beiden Gruppen gemeinsam ist und weiter mindestens eine Kompressionsspule (L47, L48) aufweist, die in Reihe mit den beiden Kondensatoren liegt, derart, daß sie an eine Ausgangslast (C49, Z7) des Generatores einen Ausgangsimpuls des Generators liefert, dessen Spannung durch Additiuon der Spannungen der Ausgangsimpulse der beiden Gruppen erhöht ist, wobei gleichzeitig die beiden Gruppen entkoppelt sind.

7. Generator nach Anspruch 5, in welchem jede Basisschaltung (C13, T6, L13, C14, L14) am Ausgang eine Zeitkompressionsstufe aufweist (C14, L14), welche die Primärwicklung des Spannungserhöhungstransformators (Tr4) speist.

8. Generator nach Anspruch 1, in welchem jeder Basiskreis folgende Komponenten aufweist:
   - einen Speicherkondensator (C13),
   - Mittel (S4, DA6, LA6) zum Laden dieses Kondensators,
   - einen Auslösethyristor (T6),
   - eine Wiedergewinnungsdiode (D6), die in umgekehrter Polung mit dem Thyristor zusammengeschaltet ist,
   - Auslösemittel (CC4), die den verschiedenen Bassischaltungen zum Zünden dieses Thyristors gemeinsam sind,
   - und eine Zeitkompressionsspule (L13) mit einem Kern aus sättigbarem, magnetischem Material, wobei die Spule mit diesem Kondensator und diesem Thyristor in Reihe geschaltet ist.

# FIG.1

# FIG.2

# FIG.3

# FIG.4

# FIG.5

# FIG.6

14

# FIG.7